# EUROPÄISCHE PATENTSCHRIFT

(11) **EP 0 311 994 B1**
(45) Veröffentlichungstag und Bekanntmachung des Hinweises auf die Patenterteilung: **22.03.1995**
(21) Anmeldenummer: 88116896.7
(22) Anmeldetag: 12.10.1988
(51) Int. Cl.: H01L 21/302, B24B 1/00

(54) **Verfahren zum schleierfreien Polieren von Halbleiterscheiben**
Method to polish semiconductor wafer without streaks
Procédé pour polir sans voile des disques semi-conducteurs

(30) Priorität: 16.10.1987 DE 3735158
(43) Veröffentlichungstag der Anmeldung: 19.04.1989
(73) Patentinhaber: Wacker-Chemitronic Gesellschaft für Elektronik-Grundstoffe mbH, D-84489 Burghausen (DE)
(72) Erfinder: Prigge, Helene, Dr. Dipl.-Chem., D-8044 Unterschleissheim (DE); Schnegg, Anton, Dr. Dipl.-Chem., D-8263 Burghausen (DE); Brehm, Gerhard, Dr. Dipl.-Ing., D-8261 Emmerting (DE); Jacob, Herbert, Dr. Dipl.-Chem., D-8263 Burghausen (DE)

(56) Entgegenhaltungen:
- DE-A- 2 247 067
- DE-A- 2 531 431
- FR-A- 2 322 456
- IBM TECHNICAL DISCLOSURE BULLETIN Band 23 Nr. 9, Februar 1981, Seite 4144, New York, US; R.D. BURDICK et al.: "Single Step Wafer Processsing"
- PATENT ABSTRACTS OF JAPAN Band 7, Nr. 263(C-196), 24. November 1983; & JP-A-58145604

## Beschreibung

Die Erfindung betrifft ein Verfahren zum schleierfreien Polieren von Halbleiterscheiben in einem Einstufenprozeß, bei dem in der Anfangsphase ein Poliersol, -gel oder feste Polierkomponenten enthaltendes, alkalisches Poliermittel auf das Poliertuch aufgebracht wird.

Ein solches Verfahren ist aus der DE-A- 25 31 431 bzw. der entsprechenden US-A- 40 70 799 bekannt. In der Endphase, also der Phase des Poliervorganges, in der die eigentliche schleierfreie Politur bewirkt wird, wird dabei dem Poliermittel der Anfangsphase ein aus 0.1 bis 10 Gew.-%, bezogen auf Poliermittel, eines anionenaktiven und/oder nichtionogenen, keinen Stickstoff im Molekül enthaltenden Tensids bestehender Poliermittelzusatz zugefügt. Da bei dieser Verfahrensweise jedoch bei einer nachfolgenden Charge von Halbleiterscheiben die im Poliertuch hängenden Tenside den Polierabtrag der ersten Stufe verringern können, wird empfohlen, den Polierprozeß als Zweistufenprozeß, d.h. aufgetrennt auf zwei verschiedene Poliermaschinen und in eine den Abtrag bewirkende Polierstufe und eine die schleierfreie Politur bewirkende Polierstufe, durchzuführen.

Auch bei der aus der DE-A- 22 47 067 bzw. der entsprechenden US-A- 38 74 129 bekannten Methode wird ein Zweistufenprozeß durchgeführt, wobei in der zweiten Stufe eine Poliersuspension eingesetzt wird, der 1 bis 10 Vol% eines einwertigen Alkohols mit 3 bis 5 Kohlenstoffatomen und 0,01 bis 0,5 Gew.-% Polyvinylalkohol zugesetzt sind. Beide an sich sehr leistungsfähigen Verfahren liefern jedoch nur als 2-Stufen-Prozesse beispielsweise in Bezug auf Abtragsraten und Schleierfreiheit der erhaltenen Scheiben ausgezeichnete Ergebnisse.

Die Aufgabe der Erfindung bestand darin, ein Verfahren anzugeben, nach dem sich schleierfrei polierte Halbleiter- und insbesondere Siliciumscheiben in einem Einstufenprozeß, also vor allem ohne Gerätewechsel und Unterbrechung des Polierprozesses, erhalten lassen.

Gelöst wird die Aufgabe durch ein Verfahren wie es in Anspruch 1 definiert ist.

Bei dem Verfahren wird während der im alkalischen pH-Bereich ablaufenden Anfangsphase des Poliervorganges vorzugsweise ein auf einem pH-Wert von 11 bis 13 eingestelltes Poliermittel eingesetzt. Die Einstellung des pH-Wertes kann dabei in bekannter Weise z.B. durch den Einsatz von geeigneten wäßrigen Puffersystemen, wie etwa einem Dinatriumhydrogenphosphat/Natronlauge-Puffer oder einem Kaliumchlorid/Natronlaugepuffer erfolgen. Der Einsatz von Puffersystemen ist jedoch nicht zwingend vorgeschrieben; der geeignete pH-Bereich kann auch mit Hilfe von entsprechend konzentrierten bzw. verdünnten alkalischen wäßrigen Lösungen von z.B. Natron- oder Kalilauge, Natrium- oder Kaliumcarbonat, Natriumacetat oder anderen alkalisch reagierenden und die Scheiben nicht unzulässig verunreinigenden Salzen eingestellt werden.

Als zusätzliche Komponente enthält das in der Anfangsphase eingesetzte Poliermittel 1 bis zu 20 Vol% eines Poliersols oder -gels, günstig auf Kieselsäurebasis, oder einer festen Polierkomponente wie z.B. Quarzmehl oder Silikate bzw. Fluoro-silikate z.B. des Natriums, Kaliums, Magnesiums, Calciums oder Bariums. Derartige Zusätze sind allgemein gebräuchlich und dem Fachmann zum Beispiel aus der eingangs genannten Patentliteratur bekannt; sie bedürfen hier daher keiner näheren Erläuterung.

In der Regel wird für die Anfangsphase des Poliervorganges, in welcher es hauptsächlich auf dem Materialabtrag ankommt, nach Maßgabe des gewünschten Abtrags und der Abtragsrate eine Zeitdauer von 5 bis 100 Minuten eingehalten, wobei gängige Abtragswerte im Bereich von 10 - 60 » m liegen. Diese Angaben sind als richtwerte, nicht jedoch im Sinne einer Beschränkung zu verstehen.

Das Poliermittel kann in der üblichen Weise auf das Poliertuch aufgebracht werden, beispielsweise indem die fertige Suspension aus einem Reservoir über Zuleitungen an die Einsatzstelle gepumpt wird und dort, ggf. nach Einstellung einer gewünschten Durchflußrate mittels Durchflußregulans, über das Poliertuch verteilt wird. Überschüssige bzw. verbrauchte Polierflüssigkeit wird unterhalb des Poliertisches in einer Auffangeinrichtung gesammelt und kann dann entsorgt oder nach einem Aufbereitungsschritt wieder eingesetzt werden.

Wenn der gewünschte Abtrag erreicht ist, in der Regel also nach der durch die Abtragsrate vorgegebenen Zeitdauer des Poliervorganges, wird die Anfangsphase in die Endphase übergeleitet, bei welcher anstelle des Materialabtrages bei der Politur die Erzeugung einer schleierfreien Oberfläche im Vordergrund steht.

Zu diesem Zweck wird ohne Unterbrechung des Poliervorganges der pH-Wert, der auf das Poliertuch aufgebrachten wäßrigen Lösung in den Bereich von 3 bis 8, vorzugsweise 3 bis 7 abgesenkt. Dies kann beispielsweise dadurch geschehen, daß durch Ansäuern des Poliermittels der Anfangsphase der pH-Wert in den gewünschten Bereich abgesenkt wird. Außerdem besteht z.B. auch die Möglichkeit, daß das Poliermittel der Anfangsphase durch eine den gewünschten pH-Wert aufweisende wäßrige Säure- oder Pufferlösung ersetzt wird, beispielsweise über ein Dreiwegehahnsystem.

Geeignete Säuren sind beispielsweise insbesondere Carbonsäuren wie Citronensäure oder Weinsäure, welche wegen ihrer leichten Handhabbarkeit bevorzugt eingesetzt werden, während beispielsweise der prinzipiell möglichen Verwendung von Essig- oder Ameisensäure schon durch die Geruchsbelästigung Grenzen gesetzt sind. Daneben ist der Einsatz von verdünnten wässrigen Mineralsäuren wie Salzsäure, Schwefelsäure oder Phosphorsäure grundsätzlich nicht ausgeschlossen. Bewährt haben sich auf Puffersysteme, die in dem pH-Bereich von 3 bis 7 wirksam sind, wie z.B. Essigsäure/Acetat-, Citronensäure/Citrat-, oder Phthalsäure/Phthalatpuffer.

Der in der Endphase des Poliervorganges eingesetzten Polierlösung werden noch Zusatzstoffe beigefügt, die die Bildung von schleierfreien Halbleiteroberflächen unterstützen. Solche Stoffe sind insbesondere Alkohole, vorzugsweise mit mindestens 2 Kohlenstoffatomen im Molekül. Dabei können einwertige oder mehrwertige, aromatische, aliphatische oder heterocyclische Alkohole eingesetzt werden. Eine Siliciumoganische Verbindung kann auch ausgewählt werden. Als günstig hat sich auch der Einsatz von Silanolen erwiesen. Beispiele für besonders gut geeignete Alkohole sind Ethanol, Isopropanol, n-Butanol, Tertiärbutanol, 1-Methoxy-propan-2-ol, Trimethyl-silanol, Cyclohexanol, Glycerin oder Phenol. Eine andere Möglichkeit besteht darin, Verbindungen zuzufügen, aus denen sich in situ der gewünschte Zusatzstoff bildet, wie z.B. Hexamethyldisilazan, das dann hydrolytisch in Trimethylsilanol gespalten wird.

Grundsätzlich können auch andere polare organische Verbindungen als Zusatzstoffe verwendet werden, sofern sie nicht zu stark alkalisch wirken und den pH-Wert der Polierlösung über die Obergrenze von 8 anheben. Beispielhaft seien hier Ether und Polyether wie etwa Diethylenglykoldiethylether oder-dimethylether, Dioxan, Hexamethyldisiloxan oder Dimethyldimethoxysilan, Ester wie Butylacetat, Amide wie Acetamid oder Dimethylacetamid und Ketone wie Acetylaceton genannt.

Derartige Zusatzstoffe, die im Molekül über hydrophile und hydrophobe Gruppen verfügen, werden in Konzentrationen von 0,01 bis 10 Vol.-%, bevorzugt 0,1 bis 5 Vol.-%, jeweils bezogen auf die Polierlösung, eingesetzt. Dabei können auch zwei- oder mehrkomponentige Mischungen wie z.B. n-Butanol/ Ethanol, n-Butanol/Glykol oder Trimethylsilanol/Ethanol, typisch in Mischungsverhältnissen von 1:5 bis 5:1, vorteilhaft 1:2 bis 2:1 eingesetzt werden.

Zusätzlich zu diesen genannten Zusatzstoffen kommen auch oberflächenaktive Stoffe in Frage, sofern gewährleistet ist, daß der pH-Bereich von 3 bis 8 nicht verlassen wird. Geeignet sind beispielsweise Tenside auf Alkylphenolbasis, wie z.B. Nonylphenolpolyglykolether, oder auf Alkyl- oder Alkylarylsulfonatbasis, wie etwa Sulfosuccinate oder auch Polyacrylate. Der Konzentrationsbereich, in dem solche Stoffe der Polierlösung zugesetzt werden, beträgt zweckmäßig weniger als 0,1 Vol.-% jeweils bezogen auf die Polierlösung.

Als besonders günstig haben sich solche Zusatzstoffe erweisen, die im sauren bis schwach alkalischen Bereich eine deutliche Verminderung des Polierabtrages bewirken, diese Eigenschaft aber im alkalischen Bereich weitgehend verlieren. Auf diese Weise können Störungen durch Desaktivierung des Poliervorganges in der Anfangsphase bei der nachfolgenden Charge Halbleiterscheiben vermieden oder gering gehalten werden.

Gemäß einer bevorzugten Ausführungsform des Verfahrens werden der Polierlösung in der Endphase zusätzlich noch eine oder mehrere der eingangs genannten festen Polierkomponenten, oder ein Poliergel, insbesondere ein Poliersol zugesetzt. Der Anteil am Poliermittel kann dabei bis zu 10 Vol%, vorteilhaft bis 5 Vol% betragen. Falls ein solcher Zusatz erfolgt, wird zweckmäßig derjenige Zusatzstoff ausgewählt, der auch dem Poliermittel der Anfangsphase zugefügt wurde; dies ist jedoch nicht zwingend vorgeschrieben.

Für die Endphase des Poliervorganges hat sich im allgemeinen eine Zeitdauer von 3 bis 20 Minuten als ausreichend erwiesen. Dabei kann das vorgesehene Poliermittel bereits fertig gemischt mit Zusatzstoffen und Komponenten in einem Reservoir vorgelegt werden, aus dem es dann über Zuleitungen mittels Pumpen auf das Poliertuch aufgebracht werden kann. Gleichfalls möglich sind jedoch Verfahrensweisen, bei denen die jeweils vorgesehenen Bestandteile des Poliermittels in separaten Vorratsgefäßen vorgelegt werden und erst in den Zuleitungen oder einer vorgeschalteten Mischstation zu der Poliermischung vereinigt werden, die schließlich auf das Poliertuch gelangt.

Eine vorteilhafte Variante des erfindungsgemäßen Verfahrens besteht darin, daß zwischen die Anfangs- und Endphase des einstufigen Poliervorganges eine Zwischenphase eingeschaltet wird, in der ein Poliermittel auf das Poliertuch aufgebracht wird, dessen pH-Wert gegenüber dem Poliermittel der Anfangsphase geringfügig erniedrigt und auf einen Wert von 9 bis 11 eingestellt ist. Dies kann beispielsweise mittels eines Borat- oder Hydrogencarbonat-Puffers, oder oftmals sogar durch einfaches Verdünnen geschehen.

Zweckmäßig enthält das Poliermittel der Zwischenphase bis zu 10 Vol% des Poliersols, -gels oder der festen Polierkomponente, die auch dem Poliermittel der Anfangsphase zugefügt wurde. Grundsätzlich kann jedoch auch auf andere der eingangs beispielhaft genannten und geeigneten Zusatzstoffe zurückgegriffen werden.

Durch die zusätzliche Zwischenphase wird ein schonenderer Übergang von der alkalischen Anfangsphase in die saure Endphase des Poliervorganges erreicht, was letztlich der Oberflächenqualität der erhaltenen Halbleiterscheiben zugute kommt. Im allgemeinen ist für die Zwischenphase eine Zeitdauer von 2 bis 10 Minuten ausreichend. Anschließend kann analog dem Vorgehen bei direktem Übergang von der Anfangs- in die Endphase das Poliermittel der Endphase auf das Poliertuch aufgebracht werden, ohne daß der Poliervorgang unterbrochen zu werden braucht.

Nach Abschluß der Endphase können die erhaltenen, eine schleierfreie Oberfläche besitzenden Halbleiterscheiben entnommen und ggf. nach einem Reinigungsschritt weiterverarbeitet werden. Anschließend kann der Poliertisch mit einer neuen Charge Halbleiterscheiben beschickt und die Anfangsphase des nächsten Poliervorganges eingeleitet werden.

Das erfindungsgemäße Verfahren kann sowohl bei der Einseiten- als auch bei der Zweiseitenpolitur eingesetzt werden. Es eignet sich insbesondere für das Polieren von Siliciumscheiben, wenngleich es grundsätzlich auch für andere Element- oder Verbindungshalbleiter wie z.B. Germanium oder Galliumarsenid in Frage kommt.

Bei den erhaltenen Scheiben läßt sich bei der konventionellen Überprüfung mit bloßem Auge im kollimierten Licht das Auftreten von sog. Schleier (in der Fachsprache oft auch als "haze" bezeichnet) nicht nachweisen, d.h. die Oberfläche erscheint nicht als milchig-trübe, sondern einwandfrei glänzende Fläche. Auch mit empfindlicheren Meßmethoden, bei denen die Oberfläche mit Laserstrahlen abgetastet und dabei das Streulicht gemessen wird (vgl. z.B. die deutsche Patentanmeldung mit dem Aktenzeichen P 36 37 477.6-52), läßt sich der für nicht schleierfrei polierte Halbleiteroberflächen typische Verlauf der Streulichkurven nicht feststellen. Da sich beim Schleierfrei-Polieren nach dem erfindungsgemäßen Verfahren die Konzentration der erforderlichen Zusatzstoffe gering halten läßt und durch die verschiedenen pH-Bereiche in der Anfangs- und der Endphase auch eine Aktiverung bzw. Desaktivierung dieser Zusatzstoffe möglich ist, kann somit auf Mehrstufenprozesse mit ihrem apparitiv aufwendigen und zeitraubenden Gerätewechsel und den besonders riskanten Anfahrvorgängen verzichtet werden. Dies wirkt sich insbesondere bei der Zweiseitenpolitur günstig aus.

Nachstehend wird das Verfahren anhand von Ausführungsbeispielen näher erläutert:

### Beispiel 1:

In einer handelsüblichen 2-Seiten-Poliermaschine wurden jeweils 5 Siliciumscheiben (beidseitig geätzt, Durchmesser ca. 7,5 cm, Dicke ca. 550 » m, (100)-Orientierung) einzeln in entsprechende Läuferscheiben vorgelegt.

Während des Poliervorganges wurden die Drehteller mit unterschiedlicher Drehrichtung gedreht, wobei am Gerät ein Druck von ca. 3 bar (1 bar ≡ 10⁻⁵ Pa) eingestellt war. Mit einer Durchflußrate von ca. 50 ml/min wurde aus einem Reservoir ein 10 Vol.-% Kieselsäuresol enthaltendes, mittels Kaliumhydroxid auf pH 12,5 eingestelltes Poliermittel über ein Düsensystem auf das Poliertuch aufgebracht; die Temperatur war auf ca. 30°C eingestellt. Der pH-Wert wurde -wie auch bei den weiteren Beispielen - jeweils mittels einer geeichten pH-Elektrode gemessen.

Nach ca. 90 Minuten wurde der dem Düsensystem vorgeschaltete Dreiwegehahn umgestellt, und als Poliermittel nunmehr aus einem zweiten Reservoir eine durch Verdünnen auf pH 10 eingestellte, ca. 1 Vol.-% Kieselsäuresol enthaltende wäßrige Lösung mit derselben Durchflußrate auf das Poliertuch gepumpt. Ohne Unterbrechung des Poliervorganges wurde diese zweite Polierphase für ca. 10 Minuten beibehalten.

Danach wurde, wiederum unter Weiterführung des Poliervorganges, in der dritten Phase eine in einem weiteren Reservoir vorgelegte, 1 Vol.-% Kieselsäuresol und 2 Vol.-% Trimethlysilanol enthaltende, mittels Phosphorsäure auf pH 7 eingestellte Polierlösung (Temperatur ca. 25°C) über das Dreiwegehahn- und Düsensystem mit der gleichen Durchflußrate auf das Poliertuch gepumpt. Diese dritte Phase dauerte weitere 10 Minuten. Insgesamt betrug danach der erzielte Abtrag etwa 50 » m.

Nach Beendigung des Poliervorganges wurden die Scheiben entnommen und nach einem Reinigungsschritt auf ihre Oberflächenqualität überprüft. Bei Betrachtung im kollimierten Licht erschienen beide Scheibenoberflächen einwandfrei glänzend, das heißt, sie waren schleierfrei. Auch bei der Untersuchung nach der empfindlicheren Methode der Laserabtastung und Streulichtmessung konnte der für mit Schleier behaftete Scheiben typische Verlauf der Meßkurven nicht beobachtet werden.

In der Zwischenzeit wurde die Poliermaschine erneut mit 5 Scheiben derselben Spezifikation beladen. Diese wurden in der gleichen Art und Weise poliert und danach auf Schleierfreiheit untersucht. Auch diese Scheiben erwiesen sich als schleierfrei; der bei der Politur erzielte Abtrag lag wiederum bei etwa 50 » m.

In genau der gleichen Weise wurden insgesamt 20 Polierfahrten durchgeführt. Dabei ließ sich weder in Bezug auf Schleierfreiheit der Scheiben noch auf die ermittelte Abtragsrate eine Verschlechterung feststellen.

### Vergleichsbeispiel:

Nach der in Beispiel 1 beschriebenen Verfahrensweise wurden 5 Siliciumscheiben der gleichen Spezifikation unter Einhaltung derselben Verfahrensparameter poliert. In einem ersten Polierschritt (ca. 90 Minuten) wurde bei pH 10 mit einer 5 Vol.-% Kieselsäuresol enthaltenden Polierlösung gearbeitet, welcher dann in der zweiten Bearbeitungsstufe 0,5 Gew.-% Nonylphenolpolyglykolether zugesetzt wurde.

Bei der ersten Polierfahrt wurde ein Abtrag von ca. 30 » m erzielt. Die erhaltenen Scheiben erwiesen sich im kollimierten Licht als schleierfrei. Bei der Überprüfung mit der empfindlicheren Methode der Laserabtastung und Streulichtmessung ließen sich jedoch noch geringe Schleierspuren nachweisen.

Beim Polieren der nächsten Charge Siliciumscheiben konnte bereits beim ersten Polierschritt nach 90 Minuten nur ein Abtrag von ca. 6 » m festgestellt werden. Der Poliervorgang wurde daraufhin nicht mehr weitergeführt.

### Beispiel 2:

Der Poliervorgang wurde ohne Unterbrechung unter denselben Bedingungen wie in Beispiel 1 angegeben, durchgeführt. In der ebenfalls 10 Minuten dauernden Endphase wurde jedoch eine mit Hilfe von Phosphorsäure auf pH 4 eingestellte, ca. 1 Vol.-% Kieselsäuresol und ca. 5 Vol.-% Butanol enthaltende Polierlösung auf das Poliertuch aufgebracht.

Bei einer Abtragsrate von ca. 50 » m wurden Scheiben erhalten, auf deren Oberflächen sich weder im kollimierten Licht noch mit der Laser-Streulicht-Methode Schleier nachweisen ließ.

Auch mit dieser Poliermittelsequenz konnten bei nahezu gleichbleibender Abtragsrate bei 20 Polierfahrten einwandfrei schleierfreie Scheiben erhalten werden.

### Beispiel 3:

Gemäß der in Beispiel 1 beschriebenen Verfahrensweise wurden Siliciumscheiben beidseitig poliert, wobei jedoch auf die Zwischenphase verzichtet wurde. In der Anfangsphase (ca. 90 Minuten) kam dabei ein Poliermittel zum Einsatz, das 5 Vol.-% Kieselsäuresol enthielt und mit Kaliumhydroxid auf einen pH-Wert von 12,5 eingestellt war. In der Endphase des Poliervorganges (ca. 20 Minuten) wurde eine 2 Vol.-% 1-Methoxy-propan-2-ol enthaltende Polierlösung mit pH 7,3 auf das Poliertuch gepumpt.

Die erhaltenen Scheiben waren auf der Ober- und Unterseite völlig schleierfrei; der Polierabtrag betrug ca. 50 » m. Auch in diesem Fall ließen sich hintereinander 20 Polierfahrten ohne Verringerung der Oberflächenqualität der Scheiben und der Abtragsrate durchführen.

### Beispiel 4:

In einer 1-Seitenpoliermaschine für die Einzelpolitur von Halbleiterscheiben wurde eine Siliciumscheibe (Durchmesser ca. 7,5 cm (100)-Orientierung, ca. 550 » m Dicke) bei 300 U/min des Poliertellers poliert. In der Anfangsphase (ca. 30 Minuten) wurde dabei mit einer Durchflußrate von ca. 30 ml/min eine ca. 5 Vol.-% Kieselsäuresol enthaltende Polierlösung, deren pH-Wert mittels Kaliumhydroxid auf ca. 12,5 eingestellt war, auf das Poliertuch aufgebracht, wobei ein Druck von ca. 0,6 bar und eine Temperatur von etwa 40°C eingestellt war. Danach wurde der Druck auf ca. 0,1 bar und die Temperatur auf ca. 35°C abgesenkt. Als Poliermittel wurde nun zunächst 5 Minuten lang eine ca. 5 Vol.-% Kieselsäuresol enthaltende, durch Verdünnen auf einen pH-Wert von 10 eingestellte Lösung mit einer Durchflußrate von 90 ml/min zugeführt. Danach wurde, bei unveränderten Druckund temperaturbedingungen, während weiterer 12 Minuten eine mittels Zitronensäure auf pH 7 eingestellte, 1 Vol.-% Kieselsäuresol und 4 Vol.-% n-Butanol enthaltende Lösung auf das Poliertuch gepumpt.

Die nach Beendigung des Polierens entnommene gereinigte und kontrollierte Scheibe erwies sich als völlig schleierfrei.

Insgesamt wurden nach dieser Verfahrensweise nacheinander 16 Polierfahrten durchgeführt, wobei stets schleierfreie Scheiben erhalten wurden. Die erzielten Abtragsraten lagen zwischen 50 und 60 » m.

## Patentansprüche

1. Verfahren zum schleierfreien Polieren von Halbleiter-oberflächen in einem Einstufenprozeß, bei dem in der Anfangsphase des Poliervorganges ein Poliersol, -gel oder feste Polierkomponenten enthaltendes, alkalisches Poliermittel auf das Poliertuch aufgebracht wird, dadurch gekennzeichnet, daß in der Endphase des Poliervorganges der pH-Wert abgesenkt wird indem eine Polierlösung auf das Poliertuch aufgebracht wird, die auf einen pH-Wert von 3 bis 8 eingestellt ist, die eine oder mehrere polare Verbindungen und/oder einen oberflächenaktiven Stoff enthält, wobei die polaren Verbindungen hydrophile und hydrophobe Gruppen enthalten, aus der Gruppe der Alkohole, Ketone, Ether, Ester oder Amide ausgewählt sind und ihre Konzentration 0,1 bis 10 Vol.-% beträgt und wobei die Konzentration des oberflächenaktiven Stoffes unter 0,1 Vol.-% beträgt.

2. Verfahren nach Anspruch 1, dadurch gekennzeichnet, daß der Polierlösung zusätzlich bis zu 10 Vol% Poliersol, -gel, oder feste Polierkomponenten zugesetzt werden.

3. Verfahren nach den Ansprüchen 1 oder 2, dadurch gekennzeichnet, daß als polare Verbindung eine siliciumorganische Verbindung ausgewählt wird.

4. Verfahren nach einem oder mehreren der Ansprüche 1 bis 3, dadurch gekennzeichnet, daß in der Anfangsphase ein auf einen pH-Wert von 11 bis 13 eingestelltes, 1 bis zu 20 Vol-% eines Poliersols, -gels oder einer festen Polierkomponente enthaltendes Poliermittel eingesetzt wird.

5. Verfahren nach einem oder mehreren der Ansprüche 1 bis 4, dadurch gekennzeichnet, daß zwischen Anfangs- und Endphase eine Zwischenphase eingeschaltet wird, in der ein auf einen pH-Wert von 9 bis 11 eingestelltes, bis zu 10 Vol% eines Poliersols, -gels oder einer festen Polierkomponente enthaltendes Poliermittel eingesetzt wird.

6. Verfahren nach Anspruch 5, dadurch gekennzeichnet, daß die Zwischenphase auf eine Zeitdauer von 2 bis 10 Minuten ausgedehnt wird.

7. Verfahren nach einem oder mehreren der Ansprüche 1 bis 6, dadurch gekennzeichnet, daß die Endphase auf eine Zeitdauer von 3 bis 20 Minuten ausgedehnt wird.

8. Verfahren nach einem oder mehreren der Ansprüche 1 bis 7, dadurch gekennzeichnet, daß die Zeitdauer der Anfangsphase auf 5 bis 100 Minuten ausgedehnt wird.

9. Verwendung von Polierlösungen beim schleierfreien Polieren von Halbleiteroberflächen in einem Einstufenprozeß, die auf einen pH-Wert von 3 bis 8 eingestellt sind, die eine oder mehrere polare Verbindungen und/oder einen oberflächenaktiven Stoff enthalten, wobei die polaren Verbindungen hydrophile und hydrophobe Gruppen enthalten, aus der Gruppe der Alkohole, Ketone, Ether, Ester oder Amide ausgewählt sind und ihre Konzentration 0,1 bis 10 Vol.-% beträgt und wobei die Konzentration des oberflächenaktiven Stoffes unter 0,1 Vol.-% beträgt.

10. Verwendung nach Anspruch 9, dadurch gekennzeichnet, daß die Polierlösungen zusätzlich bis zu 10 Vol% eines Poliersols, -gels oder fester Polierkomponenten enthalten.

## Claims

1. Process for haze-free polishing of semiconductor surfaces in a one-stage process in which a polishing sol or gel, or alkaline polishing agent containing solid polishing components, is applied to the polishing cloth in the initial phase of the polishing operation, characterized in that, in the final phase of the polishing operation the pH is lowered by a polishing solution being applied to the polishing cloth, which solution is adjusted to a pH of 3 to 8 and contains one or more polar compounds and/or a surface-active substance, the polar compounds containing hydrophilic and hydrophobic groups, being selected from the group comprising the alcohols, ketones, ethers, esters or amides and their concentration being 0.1 to 10% by volume, and the concentration of the surface-active substance being less than 0.1% by volume.

2. Process according to Claim 1, characterized in that up to 10% by volume of polishing sol or gel, or solid polishing components are additionally added to the polishing solution.

3. Process according to Claim 1 or 2, characterized in that an organosilicon compound is selected as polar compound.

4. Process according to one or more of Claims 1 to 3, characterized in that a polishing agent adjusted to a pH of 11 to 13 and containing from 1 to 20% by volume of a polishing sol or gel, or a solid polishing component is used in the initial phase.

5. Process according to one or more of Claims 1 to 4, characterized in that, between the initial and final phase, an intermediate phase is inserted in which a polishing agent adjusted to a pH of 9 to 11 and containing up to 10% by volume of a polishing sol or gel, or a solid polishing component is used.

6. Process according to Claim 5, characterized in that the intermediate phase is extended to a time duration of 2 to 10 minutes.

7. Process according to one or more of Claims 1 to 6, characterized in that the final phase is extended to a time duration of 3 to 20 minutes.

8. Process according to one or more of Claims 1 to 7, characterized in that the time duration of the initial phase is extended to 5 to 100 minutes.

9. Use of polishing solutions in the haze-free polishing of semiconductor surfaces in a one-stage process, which solutions are adjusted to a pH of 3 to 8 and contain one or more polar compounds and/or a surface-active substance, the polar compounds containing hydrophilic and hydrophobic groups, being selected from the group comprising the alcohols, ketones, ethers, esters or amides and their concentration being 0.1 to 10% by volume, and the concentration of the surface-active substance being less than 0.1% by volume.

10. Use according to Claim 9, characterized in that the polishing solutions additionally contain up to 10% by volume of a polishing sol or gel, or solid polishing components.

## Revendications

1. Procédé pour polir sans voile des surfaces semi-conductrices en une étape, dans lequel, dans la phase initiale du processus de polissage, un produit à polir alcalin contenant un sol de polissage, un gel de polissage ou des composants de polissage solides est appliqué sur le chiffon de polissage, caractérisé en ce que dans la phase finale du processus de polissage la valeur pH est abaissée pendant qu'une solution de polissage est appliquée sur le chiffon de polissage, laquelle solution est réglée sur une valeur pH de 3 à 8, contient une ou plusieurs combinaisons polaires et/ou une substance active en surface, les combinaisons polaires comprennent des groupes hydrophiles et hydrophobes, sont choisies parmi le groupe des alcools, des cétones, des éthers, des esters ou des amides, leur concentration est comprise entre 0.1 et 10 % en volume et la concentration de la substance active en surface est inférieure à 0.1 % en volume.

2. Procédé selon la revendication 1, caractérisé en ce que jusqu'à 10 % en volume de sol de polissage, de gel de polissage ou de composants de polissage solides ont été ajoutés en plus à la solution de polissage.

3. Procédé selon les revendications 1 ou 2, caractérisé en ce qu'une combinaison organique de silicium est choisie comme combinaison polaire.

4. Procédé selon une ou plusieurs des revendications 1 à 3, caractérisé en ce que dans la phase initiale, on utilise un produit à polir contenant jusqu'à 20 % en volume d'un sol de polissage, d'un gel de polissage ou d'un composant de polissage solide, réglé sur une valeur pH de 11 à 13.

5. Procédé selon une ou plusieurs des revendications 1 à 4, caractérisé en ce qu'une phase intermédiaire est raccordée entre la phase initiale et la phase finale, dans laquelle on utilise un produit à polir contenant jusqu'à 10 % en volume d'un sol de polissage, d'un gel de polissage ou d'un composant de polissage solide, réglé sur une valeur pH de 9 à 11.

6. Procédé selon la revendication 5, caractérisé en ce que la phase intermédiaire s'étend sur une durée de 2 à 10 minutes.

7. Procédé selon une ou plusieurs des revendications 1 à 6, caractérisé en ce que la phase finale s'étend sur une durée de 3 à 20 minutes.

8. Procédé selon une ou plusieurs des revendications 1 à 7, caractérisé en ce que la durée de la phase initiale est comprise entre 5 et 100 minutes.

9. Utilisation de solutions de polissage lors du polissage sans voile de surfaces semi-conductrices en une étape, qui sont réglées sur une valeur pH de 3 à 8, qui contiennent une ou plusieurs combinaisons polaires et/ou une substance active en surface, où les combinaisons polaires contiennent des groupes hydrophiles et hydrophobes, sont choisies parmi le groupe des alcools, des cétones, des éthers, des esters ou des amides, leur concentration étant comprise entre 0.1 et 10 % en volume et où la concentration de la substance active en surface est inférieure à 0.1 % en volume.

10. Utilisation selon la revendication 9, caractérisée en ce que les solutions de polissage contiennent en plus jusqu'à 10 % en volume d'un sol de polissage, d'un gel de polissage ou de composants de polissage solides.
